# EUROPÄISCHE PATENTSCHRIFT

(11) **EP 2 842 147 B1**
(45) Veröffentlichungstag und Bekanntmachung des Hinweises auf die Patenterteilung: **18.05.2016**
(21) Anmeldenummer: 13714586.8
(22) Anmeldetag: 25.03.2013
(51) Int. Cl.: H01H 9/00

(54) **VERFAHREN ZUR FUNKTIONSÜBERWACHUNG EINES STUFENSCHALTERS**
METHOD FOR MONITORING A TAP CHANGE
PROCÉDÉ DE SURVEILLANCE D'UN SÉLECTEUR DE PRISES

(30) Priorität: 27.04.2012 DE 102012103736
(43) Veröffentlichungstag der Anmeldung: 04.03.2015
(73) Patentinhaber: Maschinenfabrik Reinhausen GmbH, 93059 Regensburg (DE)
(72) Erfinder: BIERINGER, Alfred, 94333 Geiselhörig (DE); HOCHMUTH, Harald, 93149 Nittenau (DE); PLITZKO, Dominik, 93057 Regensburg (DE); SCHMID, Sebastian, 93161 Sinzing (DE)
(86) Internationale Anmeldenummer: PCT/EP2013/056250
(87) Internationale Veröffentlichungsnummer: WO 2013/160046

(56) Entgegenhaltungen:
- DE-B3- 10 344 142
- DE-B3-102010 033 195
- DE-C1- 19 744 465
- DE-C1- 19 746 574

## Beschreibung

Die Erfindung betrifft ein Verfahren zur Funktionsüberwachung eines Stufenschalters. Stufenschalter, auch als Laststufenschalter bezeichnet, sind bekannte Einrichtungen zur unterbrechungslosen Umschaltung zwischen Wicklungsanzapfungen eines Stufen(Regel-)transformators. Sie dienen gemeinsam mit dem Stufentransformator zur Spannungsregelung öffentlicher oder industrieller Energieversorgungs- und -verteilnetze. Stufenschalter werden in der Regel durch einen Motorantrieb betätigt, bei jeder Umschaltung von einer Wicklungsanzapfung auf eine andere Wicklungsanzapfung wird der Motorantrieb betätigt und betätigt seinerseits Wähler-, Vor/Grobwähler- und Lastumschalterkontakte in einer bestimmten gerätespezifischen Schaltsequenz. Es handelt sich bei Stufenschaltern um wichtige Geräte für eine einwandfreie Energieversorgung, für die eine regelmäßige Funktionsüberwachung sinnvoll und in vielen Fällen sogar geboten ist, um Funktionsstörungen rechtzeitig zu erkennen und entsprechende Abhilfemaßnahmen oder auch Sicherheitsmaßnahmen zeitnah einleiten zu können.

Aus der DE 197 44 465 C1 ist ein Verfahren zur Überwachung eines Stufenschalters bekannt, bei dem während der Lastumschaltung, d.h. während der Betätigung des Stufenschalters, die Effektivwerte von Spannung und Strom am Antriebsmotor des Motorantriebes gemessen werden und aus diesen Werten die Wirkleistung berechnet und daraus wiederum das Drehmoment ermittelt wird. Gleichzeitig erfolgt bei diesen bekannten Verfahren eine Positionserfassung der jeweils aktuellen Stellung des Stufenschalters während der Umschaltung; in der Folge werden die jeweils ermittelten Drehmomente der Position, in der sie aufgetreten sind, zugeordnet. Diese Wertepaare werden mit vorab gespeicherten Soll-Wertpaaren verglichen. Bei Abweichungen der Ist- von den Soll-Werten, die eine gewisse Schwelle überschreiten, werden Meldungen generiert - im Extremfall wird der Stufenschalter stillgesetzt.

Aus der DE 197 46 574 C1 ist ein weiteres derartiges Verfahren bekannt. Bei diesem Verfahren wird die gesamte Umschaltsequenz bei einer Betätigung des Lastumschalters in bestimmte Bereiche, sogenannte "Fenster" unterteilt; in jedem dieser Fenster werden separat die Ist- und die Soll-Werte für das jeweilige Fenster miteinander verglichen. Dieses Verfahren, bekannt als "Fenstertechnik" wird von der Anmelderin in den Monitoring-Geräten der von ihr vertriebenen Geräteserie TAPGUARD ® realisiert.

Diese bekannten Verfahren arbeiten ausnahmslos retrospektiv. Der gesamte Drehmomentverlauf bei einer Lastumschaltung an einer Wicklungsanzapfung auf eine neue Wicklungsanzapfung wird zunächst gespeichert. Nach der Beendigung der Lastumschaltung ist ein Vergleich der entsprechenden Ist- und Soll-Werte möglich. Dies gilt gerade auch bei der "Fenstertechnik". Auch hier erfolgt der Wertevergleich der einzelnen Fenster erst nach dem Abschluss der Schaltung.
Mit anderen Worten: tritt während einer Lastumschaltung eine Fehlfunktion auf, können die bekannten Verfahren dies zwar signalisieren und weitere künftige Betätigungen verhindern, die entsprechenden Warnsignale auslösende Fehlfunktion selbst kann aber nicht mehr "ungeschehen" gemacht werden. Dies kann im Extremfall zu Schäden durch diese Fehlfunktion führen.

Aufgabe der Erfindung ist es, ein verbessertes Verfahren zur Funktionsüberwachung eines Stufenschalters anzugeben.

Diese Aufgabe wird durch ein Verfahren mit den Merkmalen des ersten Patentanspruches gelöst. Die Unteransprüche betreffen besonders vorteilhafte Weiterbildungen des Verfahrens.

Die allgemeine erfinderische Idee besteht darin, bereits vor Beginn einer vorgesehenen Lastumschaltung den aktuellen Zustand des Stufenschalters zu erfassen und zu überwachen und damit sicherzustellen, dass bei einer Funktionsstörung die eigentliche Lastumschaltung gar nicht erst beginnen kann.

Dies wird nach der Erfindung dadurch erreicht, dass vor Beginn einer Lastumschaltung der Motorantrieb den Stufenschalter zunächst um einen kleinen Betrag, bei denen noch keine Betätigung der einzelnen Kontakte erfolgt, antreibt.
Dabei kann kontrolliert werden, ob sich der Stufenschalter tatsächlich bewegt. Tut er das nicht, ist der Antriebszug gebrochen, eine Blockierung aufgetreten oder eine sonstige Fehlfunktion vorhanden. Dies wird signalisiert und die eigentliche Lastumschaltung nicht zugelassen.
Alternativ oder zusätzlich kann auch das Drehmoment des Motorantriebes erfasst werden. Ist es gleich Null, ist die elektrische Verbindung unterbrochen; der Motorantrieb hat sich nicht bewegt. Ist das Drehmoment größer als ein vorab festgelegter Grenzwert, liegt eine Blockierung des Motors oder eine andere Fehlfunktion vor. Auch in einem solchen Fall kann dies signalisiert und die Lastumschaltung verhindert werden.

Unter dem oben erwähnten "kleinen Betrag", um den der Motorantrieb zunächst den Stufenschalter zur Überwachung betätigt, können, wird ein Schrittmotor verwendet, wenige Impulse verstanden werden. Bei der Verwendung eines herkömmlichen Motors in Motorantrieben, beispielsweise eines Drehstromasynchronmotors, kann eine sehr kurze Zeit verstanden werden, die etwa durch einen Timer einstellbar ist.

Besonders vorteilhaft ist es im Rahmen der Erfindung, zur Funktionsüberwachung den Stufenschalter in eine Richtung entgegen der Schaltrichtung bei der vorgesehenen späteren Lastumschaltung zu bewegen.

Das erfindungsgemäße Verfahren soll nachfolgend beispielhaft näher erläutert werden.

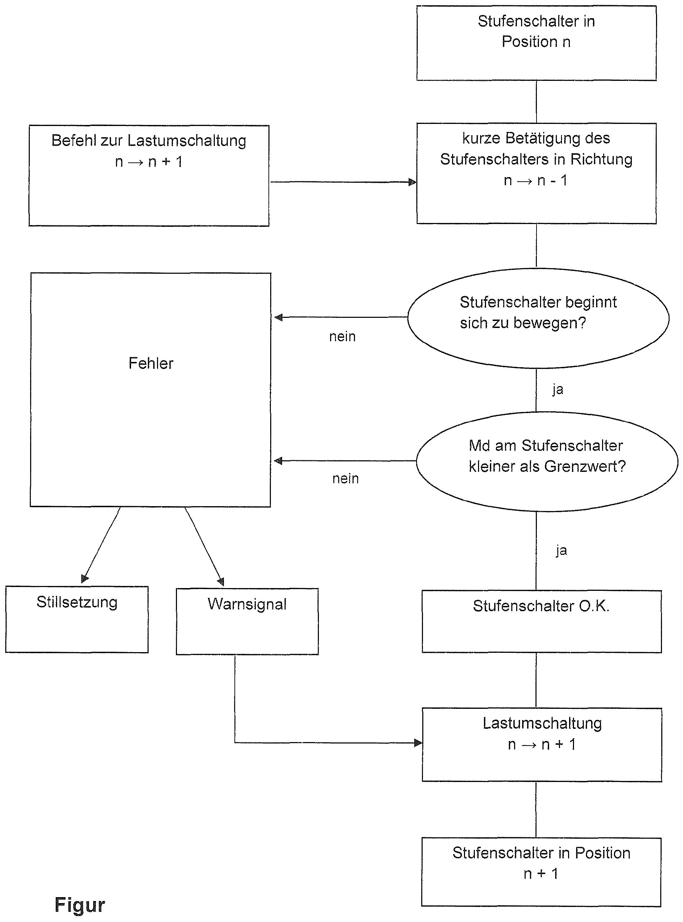

Die Figur zeigt einen schematischen Ablaufplan des erfindungsgemäßen Verfahrens.

In der Ausgangsposition befindet sich der Stufenschalter in der Position n, d.h. er beschaltet eine (beliebige) Wicklungsanzapfung des Stufentransformators.
Durch einen Spannungsregler o.ä. erhält er einen Befehl zu einer Lastumschaltung, hier beispielsweise auf die benachbarte Anzapfung n+1. Die Richtung der Lastumschaltung, d.h. von n auf n+1 oder alternativ von n auf n-1, ergibt sich aus der Information des Stellbefehles, die Spannung zu erhöhen oder zu reduzieren.
Vor Beginn der eigentlichen Lastumschaltung wird der Stufenschalter zunächst in Gegenrichtung der späteren Lastumschaltung, hier also in Richtung n-1, um einen kleinen Betrag bewegt. Die Bewegung in Gegenrichtung der späteren Lastumschaltung ist vorteilhaft, aber für das erfindungsgemäße Verfahren nicht notwendig. Eine Bewegung in dieser Richtung hat den Vorteil einer höheren Beschleunigung bei der nachfolgenden Lastumschaltung durch den verlängerten Umschaltweg.

Der kleine Betrag der erläuterten Bewegung vor der eigentlichen Lastumschaltung lässt sich bei der Verwendung eines Schrittmotors im Motorantrieb dadurch realisieren, dass der Schrittmotor nur wenige Impulse erhält. Bei einem üblichen Antriebsmotor kann dies durch eine Strombeaufschlagung nur über einen sehr kurzen Zeitraum von beispielsweise 100 ms erfolgen. Der kleine Betrag der Bewegung ist auf alle Fälle derart zu bemessen, dass die Betätigung der einzelnen Bauteile und Kontakte des Stufenschalters, die bei der Lastumschaltung in einer spezifischen Schaltsequenz erfolgt, noch nicht begonnen hat.

Anhand der Auswertung der erläuterten Bewegung des Stufenschalters um einen kleinen Betrag kann dessen Funktionsfähigkeit bereits vor der eigentlichen Lastumschaltung festgestellt werden.
So kann etwa erfasst werden, ob sich der Stufenschalter überhaupt bewegt. Dies kann dadurch ermittelt werden, dass geprüft wird, ob er seine bisherige stationäre Position n beginnt zu verlassen, indem der entsprechende Meldekontakt abgefragt wird.
Die Bewegung kann auch durch die Abfrage eines AOW-, Hall- oder optischen Sensors ermittelt werden.
Bewegt sich der Stufenschalter nicht, liegt ein Fehlerfall vor; der Antriebszug ist unterbrochen, der Antriebsmotor defekt o.ä.

Alternativ oder zusätzlich kann erfasst werden, ob das Drehmoment am Motorantrieb bei der kurzzeitigen Bewegung einen Grenzwert übersteigt. Diese Drehmomenterfassung kann mechanisch, etwa durch eine Messnabe, oder durch die aus dem Stand der Technik bekannte Auswertung des Laststromes erfolgen. Wird der Grenzwert überschritten, liegen Blockierung, Schwergängigkeit o.ä. vor - ein weiterer Fehlerfall.

Verlaufen diese Auswertungen positiv, ist der Stufenschalter in Ordnung; nachfolgend beginnt die eigentliche Lastumschaltung, bis im hier gezeigten Beispiel die neue Position n+1 erreicht ist.

Wird ein Fehler erkannt, gibt es grundsätzlich zwei Möglichkeiten, die der Verwender auswählen kann:
Der Stufenschalter kann stillgesetzt werden. Damit ist keine Lastumschaltung möglich, bis der Fehler behoben ist und ein Systemreset vorgenommen wird.
Es ist auch möglich, lediglich eine Warnmeldung zu generieren und weitere Lastumschaltungen, u.U. begrenzt auf eine bestimmte Zahl, dennoch zuzulassen.

Insgesamt ermöglicht das erfindungsgemäße Verfahren eine Funktionsüberwachung nicht retrospektiv nach einer Lastumschaltung, sondern prophylaktisch vor einer Lastumschaltung. Dies erhöht die Betriebssicherheit und Zuverlässigkeit der Energieversorgung, indem bereits vor einem möglichen Fehler bei einer Lastumschaltung dieser erkannt wird und der Stufenschalter vorsorglich stillgesetzt werden kann. Dann sind zwar - bis zur Fehlerbeseitigung - keine weiteren Spannungsregelungen mehr möglich, Folgeschäden oder ein Zusammenbruch der Spannungsversorgung sind jedoch nicht zu erwarten.

## Patentansprüche

1. Verfahren zur Funktionsüberwachung eines mittels eines Motorantriebes betätigten Stufenschalters zur unterbrechungslosen Umschaltung zwischen Wicklungsanzapfungen eines Stufentransformators,
**gekennzeichnet durch** folgende Verfahrensschritte:
- nach Erhalt eines Stellbefehls zur Lastumschaltung (n nach n+1) erfolgt eine kurzzeitige Aktivierung des Motorantriebes und damit des Stufenschalters, bei der bei ordnungsgemäßer Funktion des Stufenschalters noch keine Betätigung seiner Bauelemente und Kontakte eingeleitet wird
- nachfolgend wird erfasst, ob sich der Stufenschalter bewegt, d.h. seine bisherige stationäre Position verlassen hat und/oder das Drehmoment am Motorantrieb einen vorab festgelegten Grenzwert überschritten hat
- hat sich der Stufenschalter bewegt und/oder hat das Drehmoment am Motorantrieb den Grenzwert nicht überschritten, beginnt die eigentliche Lastumschaltung zur neuen Wicklungsanzapfung
- hat sich der Stufenschalter nicht bewegt und/oder hat das Drehmoment am Motorantrieb den Grenzwert überschritten, wird ein Fehlersignal generiert und/oder der Stufenschalter stillgesetzt.

2. Verfahren nach Anspruch 1,
**dadurch gekennzeichnet**,
nach Erhalt eines Stellbefehls zur Lastumschaltung (n nach n+1) die kurzzeitige Aktivierung des Motorantriebes und damit des Stufenschalters in der Gegenrichtung (n nach n-1) erfolgt.

3. Verfahren nach Anspruch 1 oder 2,
**dadurch gekennzeichnet,**
**dass** nach der Generierung des Fehlersignals noch eine vorab festgelegte Zahl von Lastumschaltungen zugelassen wird.

4. Verfahren nach Anspruch 1 bis 3,
**dadurch gekennzeichnet,**
**dass** der Motorantrieb einen Schrittmotor aufweist, der zur kurzzeitigen Aktivierung des Motorantriebes nur mit einer vorab festgelegten Zahl von Impulsen erregt wird.

## Claims

1. Method of function monitoring a tap changer, which is actuated by means of a motor drive, for uninterrupted switching over between winding taps of a tapped transformer,
**characterised by** the following method steps:
- after receipt of a setting command for load switching over (n to n+1) a brief activation of the motor drive and thus of the tap changer takes place, in which in the case of correct functioning of the tap changer still no actuation of its components and contacts is initiated,
- subsequently it is checked whether the tap changer moves, i.e. has left its previous stationary position, and/or the torque at the motor drive has exceeded a predetermined limit value,
- if the tap changer has moved and/or the torque at the motor drive has not exceeded the limit value the actual load switching over to the new winding tap begins or
- if the tap changer has not moved and/or the torque at the motor drive has exceeded the limit value a fault signal is generated and/or the tap changer stopped.

2. Method according to claim 1, **characterised in that** after receipt of a setting command for load switching over (n to n+1) brief activation of the motor drive and thus of the tap changer in the opposite direction (n to n-1) takes place.

3. Method according to claim 1 or 2, **characterised in that** after generation of the fault signal a predetermined number of load switchings over is still permitted.

4. Method according to claim 1 to 3, **characterised in that** the motor drive comprises a step motor, which for brief activation of the motor drive is excited by only a predetermined number of pulses.

## Revendications

1. Procédé permettant de surveiller le fonctionnement d'un commutateur à gradins actionné par un entraînement motorisé pour permettre d'effectuer une commutation sans interruption entre des prises d'enroulement d'un transformateur à gradins,
**caractérisé en ce qu'**
il comprend les étapes suivantes consistant à :
- après obtention d'un ordre de réglage pour effectuer une commutation de charge (de n vers n+1), on effectue une activation brève de l'entraînement motorisé, et ainsi du commutateur à gradins selon laquelle en présence d'un fonctionnement correct du commutateur à gradins il n'y a encore aucun actionnement de ses composants et contacts,
- on détecte ensuite si le commutateur à gradins s'est déplacé, c'est-à-dire s'il a quitté sa position stationnaire antérieure et/ou si le couple de rotation sur l'entraînement motorisé a dépassé une valeur limite fixée antérieurement,
- si le commutateur à gradins s'est déplacé et/ou si le couple de rotations sur l'entraînement motorisé n'a pas dépassé la valeur limite, on commence la commutation de charge proprement dite sur la nouvelle prise d'enroulement,
- si le commutateur à gradins ne s'est pas déplacé et/ou si le couple de rotation sur l'entraînement motorisé a dépassé la valeur limite, on génère un signal de défaut et/ou on met le commutateur à gradins à l'arrêt.

2. Procédé conforme à la revendication 1,
**caractérisé en ce qu'**
après obtention d'un ordre de réglage pour effectuer une commutation de charge (de n vers n+1), on effectue l'activation brève de l'entraînement motorisé et ainsi du commutateur à gradins en sens opposé (de n vers n-1).

3. Procédé conforme à la revendication 1 ou 2,
**caractérisé en ce qu'**
après avoir généré le signal de défaut on autorise encore un nombre de commutations de charge défini antérieurement.

4. Procédé conforme à l'une des revendications 1 à 3,
**caractérisé en ce que**
l'entraînement motorisé comprend une moteur pas à pas qui, pour permettre l'activation brève de l'entraînement motorisé n'est excité qu'avec un nombre d'impulsions fixé antérieurement.
